(19) **Europäisches Patentamt**

**European Patent Office**

**Office européen des brevets**

(11) **EP 1 179 735 A1**

(12) **EUROPÄISCHE PATENTANMELDUNG**

(43) Veröffentlichungstag:
**13.02.2002 Patentblatt 2002/07**

(51) Int Cl.⁷: **G01R 15/24**

(21) Anmeldenummer: **01810119.6**

(22) Anmeldetag: **06.02.2001**

(84) Benannte Vertragsstaaten:
**AT BE CH CY DE DK ES FI FR GB GR IE IT LI LU MC NL PT SE TR**
Benannte Erstreckungsstaaten:
**AL LT LV MK RO SI**

(30) Priorität: **12.08.2000 DE 10039455**

(71) Anmelder: **ABB RESEARCH LTD.**
**8050 Zürich (CH)**

(72) Erfinder:
• **Stanimirov, Michael**
**5400 Baden (CH)**

• **Meier, Urs**
**5415 Nussbaumen (CH)**
• **Bohnert, Klaus**
**5452 Oberrohrdorf (CH)**
• **Glock, Jürgen**
**69493 Hirschberg (DE)**

(74) Vertreter: **ABB Patent Attorneys**
**c/o ABB Business Services Ltd, Intellectual Property (SLE-I), Haselstrasse 16/699**
**5401 Baden (CH)**

(54) **Verfahren zur Messung einer elektrischen Spannung und Spannungswandler**

(57) Zur Messung einer elektrischen Spannung in einem elektro-optischen Spannungswandler wird polarisiertes Licht zweier Wellenlängen durch das Medium (1) geschickt. Ausgangsseitig wird das Licht durch einen Polarisator (10) geführt und das verbleibende Signal wird gemessen. Um die Spannung auch oberhalb der Halbwellenspannung eindeutig zu bestimmen, werden die Messresultate beider Wellenlänge miteinander verglichen und es wird derjenige Spannungswert verwendet, der mit beiden Messungen konsistent ist.

Fig. 1

**EP 1 179 735 A1**

**Beschreibung**

Technisches Gebiet

Die Erfindung betrifft ein Verfahren zur Messung einer elektrischen Spannung mit einem elektro-optischen Medium und einen Spannungswandler gemäss Oberbegriff der unabhängigen Ansprüche.

Stand der Technik

Ein elektro-optisches Medium ist ein Material, dessen Brechungsindex bzw. dessen Lichtausbreitungsgeschwindigkeit sich für mindestens eine Lichtpolarisation ändert, wenn ein elektrisches Feld angelegt wird.

Die Messung elektrischer Spannungen mittels elektro-optischer Medien ist bekannt. Ein entsprechendes Gerät wird z.B. in US 4 904 931 offenbart. Es enthält einen elektro-optischen Kristall zwischen zwei Polarisatoren. Durch den Pockels-Effekt wird im Kristall eine Änderung der Brechungsindizes erzeugt, die zu einer Modulation der Lichtintensität nach dem zweiten Polarisator führt. Diese Modulation ist allerdings periodisch von der Spannung abhängig, wobei die Periode durch die sog. Halbwellenspannung gegeben ist. Die Abhängigkeit zwischen Spannung und Ausgangssignal ist also nicht-eindeutig. Um ein eindeutiges Messresultat zu erhalten, werden in US 4 904 931 deshalb zwei Strahlen gleicher Wellenlänge durch den Kristall geführt, wobei die beiden Strahlen durch unterschiedlich starke doppelbrechende Platten treten. Durch diese Anordnung kann die Spannung auch in Bereichen oberhalb der Halbwellenspannung bestimmt werden, da ein Vergleich des Intensitätsverlaufs beider Strahlen es erlaubt, die Zahl der durchlaufenen Intensitätsminima und - maxima eindeutig zu zählen. Diese Lösung ist jedoch apparativ aufwendig und versagt bei schnellen Spannungsänderungen.

US 4 531 092 beschreibt ein Verfahren zur Messung einer elektrischen Spannung, bei welchem zwei Strahlen unterschiedlicher Wellenlänge durch einen elektro-optischen Kristall geschickt werden. Dabei wird nur einer der beiden Strahlen ausgangsseitig polarisiert, so dass die Intensität des zweiten Strahls nicht von der Spannung abhängig ist. Diese Massnahme erlaubt es, den zweiten Strahl als Referenzgrösse zu verwenden und die Genauigkeit der Messung zu verbessern.

Darstellung der Erfindung

Es stellt sich die Aufgabe, ein Verfahren und eine Vorrichtung der eingangs genannten Art bereitzustellen, die in einfacher Weise auch bei grossen Spannungen eine eindeutige Messung erlauben, d.h. die Mehrdeutigkeiten des Ausgangssignals in Abhängigkeit der am Medium angelegten Spannung sind zu reduzieren bzw. völlig aufzuheben.

Diese Aufgabe wird von den unabhängigen Ansprüchen gelöst.

Erfindungsgemäss wird das elektro-optische Medium also von zwei Lichtstrahlen unterschiedlicher Wellenlänge durchsetzt, wobei die Signale $A_1$, $A_2$ beider Lichtstrahlen nach dem Ausgangspolarisator gemessen werden. Die Signale $A_1$, $A_2$ sind nicht-eindeutige Funktionen $f_1$, $f_2$ der zu messenden elektrischen Spannung. Zur Bestimmung der Spannung wird diejenige Spannung $V_x$ ermittelt wird, für welche gilt

$$A_1 = f_1(V_x) \text{ und}$$

$$A_2 = f_2(V_x).$$

Die Spannung $V_x$ ist auf diese Weise im allgemeinen eindeutig bestimmbar. Somit wird die zusätzliche Information, die aus der Messung bei einer zweiten Wellenlänge resultiert, für eine eindeutige Spannungsbestimmung verwendet.

Das Gleichungssystem kann z.B. mittels einer Wertetabelle gelöst werden. Diese Wertetabelle kann beispielsweise eine Liste von Spannungswerten und den zugehörigen Werten $A_1$ und $A_2$ enthalten.

Die Verwendung einer Wertetabelle ist sehr einfach, sie hat aber den Nachteil, dass sie nur für bestimmte elektro-optische Koeffizienten gültig ist. Für viele elektro-optische Materialien sind diese Koeffizienten jedoch relativ stark von der Temperatur abhängig, d.h. die Funktionen $f_1$ und $f_2$ hängen von der Temperatur ab, so dass für jede Temperatur eine neue Wertetabelle abgelegt werden müsste. Deshalb erweist es sich als vorteilhaft, das Gleichungssystem direkt zu lösen, z.B. indem die Spannungen berechnet werden, die eine erste Gleichung des Gleichungssystems lösen, und dass geprüft wird, welche dieser Spannungen die zweite Gleichung des Gleichungssystems löst.

Die mit der Erfindung erzielbaren Vorteile bestehen insbesondere darin, dass die Reduktion der Mehrdeutigkeiten des Ausgangssignals in Abhängigkeit der am Medium angelegten Spannung mit einfachen Mitteln erfolgt.

Kurze Beschreibung der Zeichnungen

Weitere Ausgestaltungen, Vorteile und Anwendungen der Erfindung ergeben sich aus den abhängigen Ansprüchen und aus der nun folgenden Beschreibung anhand der Figuren. Dabei zeigen:

Fig. 1 eine schematische Darstellung eines zur Durchführung der Erfindung geeigneten Spannungswandlers,
Fig. 2 die Abhängigkeit der intensitätsmodulierten optischen Ausgangssignale von der Spannung zweier Lichtstrahlen verschiedener Wellenlänge,
Fig. 3 eine sich bei Einkopplung von zwei Lichtstrahlen verschiedener Wellenlänge ergebende Lissajous-Figur höherer Ordnung,
Fig. 4 eine sich bei Einkopplung von drei Lichtstrahlen verschiedener Wellenlänge ergebende Lissajous-Figur höherer Ordnung.

Wege zur Ausführung der Erfindung

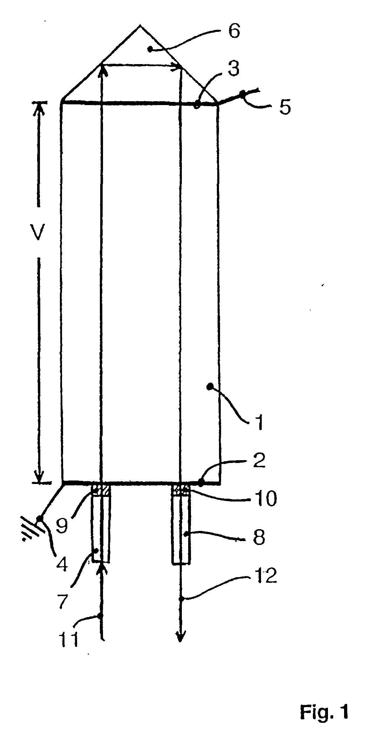

In Fig. 1 ist eine schematische Darstellung eines quaderförmigen BGO-Kristalls 1 zu erkennen, der an seinen beiden Stirnseiten mit einer Beschichtung aus einem elektrisch leitfähigen, lichtdurchlässigen Material zur Bildung von zwei Elektroden 2, 3 versehen ist. Die eine Elektrode 2 dient als Erdpotential-Anschluss 4 und die andere Elektrode 3 als Hochspannungspotential-Anschluss 5. Die zwischen den Elektroden 2, 3 angelegte Spannung ist mit *V* bezeichnet. Auf der die Elektrode 3 bildenden Stirnseite des BGO-Kristalls 1 ist ein Umlenkprisma 6 angeordnet, während sich an der die Elektrode 2 bildenden Stirnseite des BGO-Kristalls 1 zwei lineare Polarisatoren (bzw. Analysatoren) 9 bzw. 10 befinden, an welche sich Kollimatoren 7 bzw. 8 anschliessen.
Die Polarisatoren 9, 10 sind unter 45° zu den Achsen des Kristalls orientiert. Sie können zueinander parallel oder um 90° gekreuzt sein.
Ein in den Kollimator 7 eingekoppelter Lichtstrahl 11 durchläuft den Polarisator 9 und tritt polarisiert durch die Elektrode 2, in den BGO-Kristall 1 und durch die Elektrode 3, wird an den Grenzflächen des Umlenkprismas 6 reflektiert und durchläuft anschliessend die Elektrode 3, den BGO-Kristall 1, die Elektrode 2, den Polarisator 10 und den Kollimator 8. Der ausgekoppelte Lichtstrahl ist mit Ziffer 12 bezeichnet.
Wie bereits erwähnt, zielt die Erfindung auf die Aufhebung der störenden Mehrdeutigkeiten des am Kollimator 8 erfassbaren Ausgangssignals in Abhängigkeit der am Kristall angelegten Spannung ab. Zur Lösung dieses Problems wird das Verhalten des elektro-optischen Mediums bei Verwendung verschiedener Wellenlängen λ des auf die oben beschriebene Art eingekoppelten Lichtstrahles ausgenutzt.
Sind die Polarisatoren parallel, so gilt bei Lichtausbreitung entlang der optischen Achse z für die Signalstärke *A* des Lichtstrahls nach dem Polarisator 10

$$A(V) = A_0 \cdot \cos^2\left(\frac{\pi}{2} \cdot \frac{V}{V_h} + \varphi_\lambda\right) = \frac{A_0}{2} \cdot \left(1 + \cos\left(\pi \frac{V}{V_h} + \varphi_\lambda^\star\right)\right), \quad (1)$$

wobei $A_0$ die Signalamplitude, $V_h$ die Halbwellenspannung für die vorliegende Konfiguration und $\varphi\lambda$ (bzw. $\varphi\lambda^\star$) ein Modulationsoffset der Apparatur ist. Sind die Polarisatoren 9, 10 um 90° zueinander verdreht, so gilt anstelle von Gleichung (1)

$$A(V) = A_0 \cdot \sin^2\left(\frac{\pi}{2} \cdot \frac{V}{V_h} + \varphi_\lambda\right) = \frac{A_0}{2} \cdot \left(1 - \cos\left(\pi \frac{V}{V_h} + \varphi_\lambda^\star\right)\right) \quad (1')$$

Im vorliegenden Fall wird das elektrische Feld in z-Richtung des Kristalls angelegt und es gilt für die Halbwellenspannung $V_h$

$$V_h = \frac{\lambda}{2 \cdot r_{63} \cdot n^3}, \qquad (2)$$

wobei $r_{63}$ der bei der vorliegenden Konfiguration effektive elektro-optische Koeffizient des Materials, λ die Lichtwellenlänge und *n* der Brechungsindex des Kristalls in x- bzw. y-Richtung ist.

Durch das Einfügen von zusätzlichen speziellen Verzögerungsplatten zwischen dem Kristall 1 und dem zweiten Polarisator 10 wird eine zusätzliche Phasenverschiebung um $\pi/2$ eingeführt. In diesem Fall gilt anstelle von Gleichung (1):

$$A(V) = \sin\left(\pi\,\frac{V}{V_h} + \varphi_\lambda^\star\right) \cdot \frac{A_0}{2} + \frac{A_0}{2}, \qquad (1^\star)$$

Falls Gleichung (1) zur Beschreibung von $A(V)$ gilt, spricht man vom Kosinus-Kanal, und falls Gleichung (1*) $A(V)$ beschreibt, so spricht man vom Sinus-Kanal.

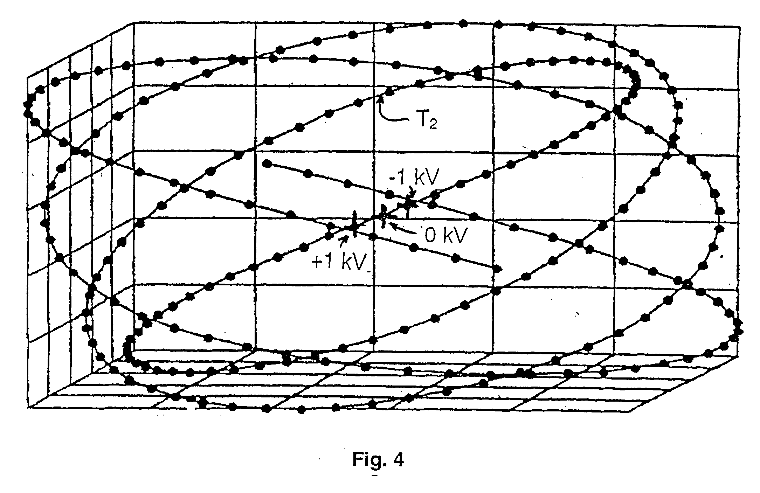

Bei Verwendung von nur einem Lichtstrahl können mit Gleichung (1) bzw. (1') und (1*) Spannungen nur bis zu einer bestimmten Höhe gemessen werden, ohne dass nachteilige Mehrdeutigkeiten des Ausgangssignals in Abhängigkeit der am Kristall angelegten Spannung auftreten (siehe Ellipse E in Fig. 4).

Die Halbwellenspannung $V_h$ ist von der Wellenlänge $\lambda$ des eingekoppelten Lichtstrahls abhängig. Werden mehrere Lichtstrahlen unterschiedlicher Wellenlänge durch den Kristall 1 geführt, so ergeben sich entsprechend unterschiedliche Halbwellenspannungen $V_h$.

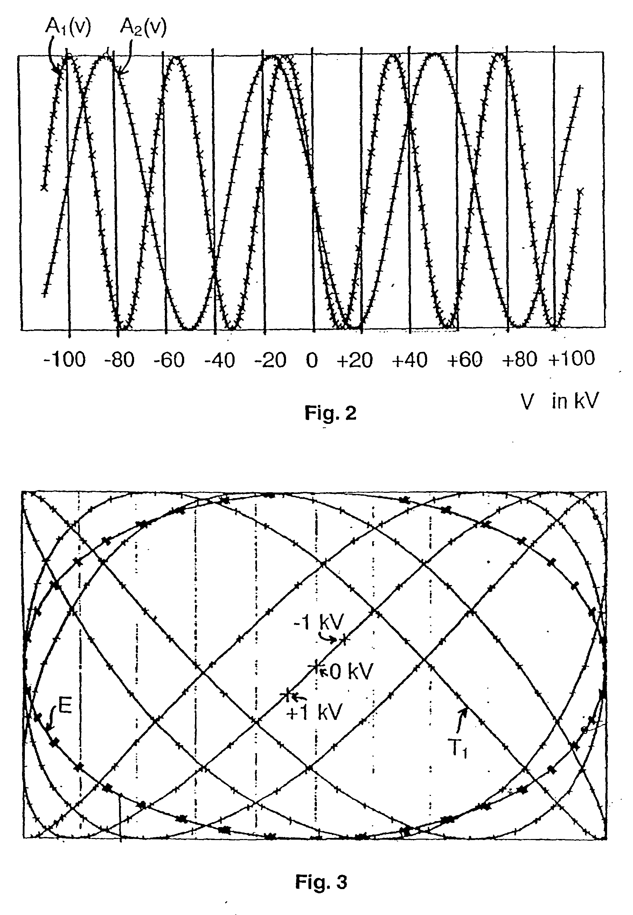

In Fig. 2 ist in diesem Zusammenhang die Abhängigkeit der intensitätsmodulierten optischen Signale $A_1$, $A_2$ von der Spannung dargestellt, wie sie sich bei Einkopplung zweier Lichtstrahlen verschiedener Wellenlänge $\lambda_1$ und $\lambda_2$ ergeben. Diese den Ausgang des Kollimators 8 verlassenden optischen Signale können über anschliessend angeordnete Fotodioden detektiert werden, was im speziellen Fall folgendes heisst: Die optischen intensitätsmodulierten Signale werden abhängig von ihrer Intensität in entsprechend skalierte elektrische Signale gewandelt und digitalisiert.

Zwei derart ein- und ausgekoppelte Lichtstrahlen unterschiedlicher Wellenlänge $\lambda_1$ und $\lambda_2$ ergeben in Abhängigkeit von der am Kristall angelegten Spannung $V$ Trajektorien der Ausgangssignale $A_1(V)$ und $A_2(V)$, die, an der x- und y-Achse eines Diagramms aufgetragen, nicht mehr Lissajous-Figuren erster Ordnung (Ellipsen, mehrdeutige Abbildung) sondern Lissajous-Figuren höherer Ordnung entsprechen. Dies ist in Fig. 3 dargestellt. Das Verhältnis der beiden Wellenlängen $\lambda_1$ und $\lambda_2$ bestimmt die Form und die Anzahl der Schnittpunkte der Lissajous-Figuren. Zu jedem Punkt der Trajektorie gehört genau ein Spannungswert. Eine Ausnahme bilden die Schnittpunkte verschiedener Äste der Trajektorie. Jedem solchen Punkt sind zwei Spannungswerte zugeordnet. Die Mehrdeutigkeit der Abbildung der Spannung auf die intensitätsmodulierten optischen Signale reduziert sich somit nur noch auf die Schnittpunkte der verschiedenen Äste der Trajektorie.

In Fig. 3 ist eine sich bei Einkopplung von zwei Lichtstrahlen verschiedener Wellenlänge ergebende Lissajous-Figur $T_1$ höherer Ordnung dargestellt.

Legt man die zu den einzelnen Punkten dieser Trajektorie gehörenden Spannungswerte V in einer Wertetabelle ab, lässt sich die Spannung einfach durch einen entsprechenden Suchalgorithmus, der die Spannung, die zu einem Punkt der Trajektorie gehört, heraussucht, rekonstruieren. Für die Werte auf den Schnittpunkten wird eine Approximation aus alten Spannungswerten herangezogen.

Werden nicht zwei, sondern drei Lichtstrahlen unterschiedlicher Wellenlänge in den Kristall eingekoppelt und die entsprechenden Signale $A_1$, $A_2$ und $A_3$ gemessen, so entstehen keine singulären Schnittpunkte mehr. Fig. 4 zeigt eine sich bei Einkopplung von drei Lichtstrahlen verschiedener Wellenlänge ergebende Lissajous-Figur $T_2$ höherer Ordnung. Wie gut zu erkennen ist, entstehen keine Schnittpunkte mehr. Bei einer Messung mit drei (oder mehr) Lichtstrahlen unterschiedlicher Wellenlänge lässt sich also für alle Spannungen ein eindeutiges Resultat berechnen.

Die Gleichungen (1), (1') bzw. (1*) lassen sich für zwei Lichtstrahlen unterschiedlicher Wellenlänge $\lambda_1$, $\lambda_2$ verallgemeinert wie folgt schreiben:

$$A_1 = f_1(V) \qquad (3a)$$

und

$$A_2 = f_2(V), \qquad (3b)$$

wobei z.B. im Falle des Sinus-Kanals (1*) mit zusätzlicher Verzögerungsplatte die nicht-eindeutigen Funktionen $f_i$ gegeben sind durch

$$f_i(V) = \sin\left(\pi \cdot \frac{V}{V_h(\lambda_i)} + \varphi_{\lambda_i}^{\star}\right) \cdot \frac{A_{0,i}}{2} + \frac{A_{0,i}}{2} \cdot (4)$$

Für den Fall paralleler Polarisatoren ist der Sinus durch den Kosinus zu ersetzen.

Im oben beschriebenen Ausführungsbeispiel wurde die Gleichungen (3a) und (3b) dadurch gelöst, dass eine Wertetabelle durchsucht wurde, die zu einer Vielzahl von Spannungen $V$ die jeweiligen Werte $f_i(V)$ enthielt. Es ist jedoch auch möglich, die Gleichungen (3a) und (3b) direkt zu lösen, indem diejenige Spannung $V_x$ ermittelt wird, die beide Gleichungen des Gleichungssystem (3a, b) löst. Hierzu können z.B. die Gleichungen (3a, b) nach $V$ aufgelöst werden und es ergibt sich mit (4)

$$V = \left(\arcsin\left(\frac{2 \cdot A_i(V)}{A_{0,i}} - 1\right) - \varphi_{\lambda_i}^{\star}\right) \cdot \frac{\lambda_i}{2\pi \cdot n^3 r_{63}} \cdot \qquad (5)$$

Zur Lösung des Gleichungssystems können z.B. aus Gleichung (5) für beide Wellenlängen die möglichen Spannungswerte im vorgesehenen Spannungsbereich berechnet werden. Im Normalfall wird es eine Spannung geben, die in den Lösungswerten für beide Wellenlängen vorkommt. In der Praxis wird diese Spannung dadurch ermittelt, dass derjenige Spannungswert $V_x$ gesucht wird, der für beide Wellenlängen mit einer nur kleinen Abweichung von z. B. 1% gefunden wurde. Mit anderen Worten werden also die Spannungen berechnet, die z.B. die Gleichung (3a) lösen, und es wird geprüft, welche dieser Spannungen gleichzeitig die zweite Gleichung (3b) löst.

Ist der entsprechende Wert bei der Wellenlänge $\lambda_1$ gleich $V_1$ und bei der Wellenlänge $\lambda_2$ gleich $V_2$, so wird für die gesuchte Spannung $V_x$ der Mittelwert von $V_1$ und $V_2$ verwendet.

An einigen Stellen, nämlich an den Kreuzungspunkten in Fig. 3, gibt es zwei Lösungen. Für diesen Fall wird die richtige Lösung über eine Vorhersage aus den in der Vergangenheit gemessenen Spannungen ermittelt. Bei Abtastraten von 20 kHz und einer Netzfrequenz von 50 oder 60 Hz ist eine Einschritt-Vorhersage ausreichend. Liegt eine der beiden Lösungen innerhalb des durch die Sensorgenauigkeit vorgegebenen Toleranzbandes in der Nähe der vorhergesagten Spannung, so kann aus ihr der Wert $V_x$ berechnet werden.

In den obigen Beispielen wird als elektro-optisches Medium ein BGO-Kristall verwendet, wobei das Feld in z-Richtung angelegt wird und das Licht sich in z-Richtung ausbreitet. Es ist auch möglich, andere Geometrien und andere elektro-optische Medien zu verwenden, wie z.B. Kristalle aus $LiNbO_3$ oder BSO oder nichtzentrisch polarisierte Polymere.

Die hier beschriebenen Techniken sind ferner auch auf Medien anwendbar, bei denen der elektro-optische Effekt nicht linear (Pockels-Effekt) sondern quadratisch (Kerr-Effekt) auftritt, wobei insbesondere die Gleichungen (4), (5) und (8) entsprechend anzupassen sind. So ist z.B. in Gleichung (4) der Sinus von einem Quadrat der angelegten Spannung zu berechnen.

Bezugszeichenliste

| 1: | BGO-Kristall |
|---|---|
| 2, 3: | Elektroden |
| 4: | Erdpotential-Anschluss |
| 5: | Hochspannungspotential-Anschluss |
| 6: | Umlenkprisma |
| 7, 8: | Kollimatoren |
| 9, 10: | Polarisatoren |
| 11, 12: | eingekoppelter und ausgekoppelter Lichtstrahl |
| $A_{0,i}$: | Signalamplituden |
| $a, b, c, d, e, f$: | Koeffizienten |
| $n$: | Brechungsindex |
| $r$: | elektro-optischer Koeffizient |
| $V$: | Spannung |
| $V_h$: | Halbwellenspannung |
| $V_x$: | Lösung des Gleichungssystems |

$\lambda$:          Lichtwellenlänge

$\lambda_1$, $\lambda_2$:        Wellenlängen der eingekoppelten Strahlen

**Patentansprüche**

1. Verfahren zur Messung einer elektrischen Spannung mit einem elektro-optischen Medium (1), wobei das Medium einem von der Spannung abhängigen elektrischen Feld ausgesetzt wird und mindestens zwei polarisierte Licht-strahlen (11) unterschiedlicher Wellenlänge ($\lambda_1$, $\lambda_2$) in das Medium (1) eingestrahlt und nach dem Medium (1) polarisiert werden, und wobei Ausgangssignale $A_1$ und $A_2$ der Lichtstrahlen gemessen werden, wobei $A_1$ und $A_2$ nicht-eindeutige Funktionen $f_1$ und $f_2$ der Spannung sind, **dadurch gekennzeichnet, dass** zur Bestimmung der Spannung diejenige Spannung $V_x$ ermittelt wird, für welche beide Gleichungen des folgenden Gleichungssystems erfüllt sind:

$$A_1 = f_1(V_x) \text{ und}$$

$$A_2 = f_2(V_x).$$

2. Verfahren nach Anspruch 1, **dadurch gekennzeichnet, dass** die Lösung des Gleichungssystems mittels einer Wertetabelle erfolgt.

3. Verfahren nach Anspruch 1, **dadurch gekennzeichnet, dass** diejenigen Spannungen berechnet werden, die eine erste Gleichung des Gleichungssystems lösen, und dass geprüft wird, welche dieser Spannungen die zweite Gleichung des Gleichungssystems löst.

4. Verfahren nach einem der vorangehenden Ansprüche, **dadurch gekennzeichnet, dass** eine spannungsinduzierte Brechungsindex-Änderung im Medium (1) über den Pockels-Effekt vom elektrischen Feld abhängt.

5. Verfahren nach einem der vorangehenden Ansprüche, **dadurch gekennzeichnet, dass** das Medium ein Kristall, insbesondere ein BGO-Kristall ist.

6. Verfahren nach einem der vorangehenden Ansprüche, **dadurch gekennzeichnet, dass** drei Lichtstrahlen unterschiedlicher Wellenlänge durch das Medium (1) gestrahlt werden.

7. Spannungswandler mit einem elektro-optischen Medium (1), insbesondere einem elektro-optischen Kristall, der zwischen zwei Elektroden (2, 3) unterschiedlichen Potentials angeordnet ist und bei dem sich beim Durchstrahlen mit einem Lichtstrahl aufgrund des elektro-optischen Effekts die Ausbreitungsgeschwindigkeit des Lichts potentialabhängig ändert, wobei mindestens zwei polarisierte Lichtstrahlen unterschiedlicher Wellenlänge ($\lambda_1$, $\lambda_2$) auf das Medium (1) eintreffen und nach dem Medium durch einen Polarisator (10) geführt sind, und wobei der Spannungswandler Auswertemittel aufweist zum Bestimmen einer über den Elektroden (2, 3) anliegenden Spannung aus Signalen $A_1$, $A_2$ der Lichtstrahlen nach dem Polarisator, **dadurch gekennzeichnet, dass** die Auswertemittel ausgestaltet sind zur Bestimmung derjenigen Spannung $V_X$, für welche das folgende Gleichungssystem erfüllt ist

$$A_1 = f_1(V_X) \text{ und}$$

$$A_2 = f_2(V_X),$$

wobei $f_1$ und $f_2$ nicht-eindeutige Funktionen sind, die die Abhängigkeit der Signale $A_1$ bzw. $A_2$ von der Spannung beschreiben.

8. Spannungswandler nach Anspruch 7, **dadurch gekennzeichnet, dass** die Auswertung der Signale $A_1$, $A_2$ auf-grund einer Wertetabelle erfolgt.

9. Spannungswandler nach einem der Ansprüche 7 oder 8, **dadurch gekennzeichnet, dass** die Ausbreitungsgeschwindigkeit des Lichts im Medium (1) aufgrund des Pockels-Effekts von der Spannung abhängt, und insbesondere dass das Medium ein BGO-Kristall ist.

10. Spannungswandler nach einem der Ansprüche 7 bis 9, **dadurch gekennzeichnet, dass** drei Lichtstrahlen unterschiedlicher Wellenlänge ($\lambda$) das Medium durchstrahlen.

Fig. 1

Fig. 2

Fig. 3

Fig. 4

**Europäisches Patentamt**

# EUROPÄISCHER RECHERCHENBERICHT

Nummer der Anmeldung

EP 01 81 0119

## EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (Int.Cl.7) |
|---|---|---|---|
| X | WO 98 05975 A (BOSSELMANN THOMAS ;BEIERL OTTMAR (DE); SIEMENS AG (DE); WILLSCH MI) 12. Februar 1998 (1998-02-12) * Seite 7, Zeile 5 – Seite 8, Zeile 27 * * Seite 10, Zeile 6 – Seite 11, Zeile 4 * * Ansprüche 3,18; Abbildungen 1,2 * | 1,2,4-10 | G01R15/24 |
| A | WO 00 37949 A (BOSSELMANN THOMAS ;MOHR STEPHAN (DE); SIEMENS AG (DE); WILLSCH MIC) 29. Juni 2000 (2000-06-29) * Zusammenfassung; Abbildung 1 * * Seite 7, Zeile 1 – Zeile 13 * | 1-3,8 | |
| A | EP 0 664 460 A (TOKIN CORP) 26. Juli 1995 (1995-07-26) * Spalte 2, Zeile 15 – Zeile 33; Abbildung 2 * | 4,5,9 | |

| | RECHERCHIERTE SACHGEBIETE (Int.Cl.7) |
|---|---|
| | G01R |

Der vorliegende Recherchenbericht wurde für alle Patentansprüche erstellt

| Recherchenort | Abschlußdatum der Recherche | Prüfer |
|---|---|---|
| MÜNCHEN | 26. Oktober 2001 | Jakob, C |

**ANHANG ZUM EUROPÄISCHEN RECHERCHENBERICHT
ÜBER DIE EUROPÄISCHE PATENTANMELDUNG NR.**

EP 01 81 0119

In diesem Anhang sind die Mitglieder der Patentfamilien der im obengenannten europäischen Recherchenbericht angeführten Patentdokumente angegeben.
Die Angaben über die Familienmitglieder entsprechen dem Stand der Datei des Europäischen Patentamts am
Diese Angaben dienen nur zur Unterrichtung und erfolgen ohne Gewähr.

26-10-2001

| Im Recherchenbericht angeführtes Patentdokument | | Datum der Veröffentlichung | Mitglied(er) der Patentfamilie | | Datum der Veröffentlichung |
|---|---|---|---|---|---|
| WO 9805975 | A | 12-02-1998 | CN | 1230257 A | 29-09-1999 |
| | | | WO | 9805975 A1 | 12-02-1998 |
| | | | EP | 0916095 A1 | 19-05-1999 |
| WO 0037949 | A | 29-06-2000 | WO | 0037949 A1 | 29-06-2000 |
| | | | EP | 1145020 A1 | 17-10-2001 |
| EP 0664460 | A | 26-07-1995 | JP | 7027806 A | 31-01-1995 |
| | | | JP | 7110346 A | 25-04-1995 |
| | | | JP | 7260832 A | 13-10-1995 |
| | | | CA | 2144080 A1 | 19-01-1995 |
| | | | CN | 1111916 A ,B | 15-11-1995 |
| | | | DE | 69427219 D1 | 21-06-2001 |
| | | | EP | 0664460 A1 | 26-07-1995 |
| | | | WO | 9502194 A1 | 19-01-1995 |
| | | | KR | 243779 B1 | 01-02-2000 |
| | | | US | 5781003 A | 14-07-1998 |

EPO FORM P0461

Für nähere Einzelheiten zu diesem Anhang : siehe Amtsblatt des Europäischen Patentamts, Nr.12/82